# EUROPÄISCHE PATENTSCHRIFT

(11) **EP 0 878 991 B1**
(45) Veröffentlichungstag und Bekanntmachung des Hinweises auf die Patenterteilung: **24.10.2001**
(21) Anmeldenummer: 98440090.3
(22) Anmeldetag: 07.05.1998
(51) Int. Cl.: H05K 7/20

(54) **Gestellrahmen mit Baugruppenträger und Belüftungseinrichtung**
Cabinet frame for supporting equipment with ventilation device
Ossature d'armoire support de baies avec dispositif de ventilation

(30) Priorität: 09.05.1997 DE 19719507
(43) Veröffentlichungstag der Anmeldung: 18.11.1998
(73) Patentinhaber: ALCATEL, 75088 Paris (FR)
(72) Erfinder: Neustadt, Alf, 70199 Stuttgart (DE)
(74) Vertreter: Schätzle, Albin, Dipl.-Phys.

(56) Entgegenhaltungen:
- DE-A- 3 408 139
- DE-U- 29 622 662
- US-A- 4 767 262

## Beschreibung

Die Erfindung betrifft einen Gestellrahmen mit Baugruppenträger und Belüftungseinrichtung zur Unterbringung in Gehäusen oder Schränken der Nachrichtentechnik. Siehe z.B. die Schrift DE-U-296 22 662.

Aus der EP-B-0 485 281 ist ein Schrank mit eingebautem Schwenkrahmen und daran befestigten Montageplatten bekannt, die auf der zur Schrankinnenseite weisenden Rückseite jeweils mehrere, mit Abstand nebeneinander in vetikaler Lage angeordnete Leiterplatten tragen. Zur Kühlung der Wärme erzeugenden Bauelemente auf den Leiterplatten dienen bedarfsweise unterhalb der Montageplatten am Schwenkrahmen befestigte Lufteinlaßschächte und Lüftereinsätze mit zwei jeweils horizontal blasenden Axiallüftern. Vorgesehene Leitbleche lenken die Luftströme vertikal um.

In der DE-A- 27 10 356 ist außerdem ein belüfteter Schrank mit einem Gestell beschrieben, das mehrere Traversen hat, die in mehreren Reihen übereinander das Abstellen von jeweils zwei Gerätegehäusen nebeneinander gestatten. Die Gerätegehäuse enthalten die zu kühlenden Baugruppen und haben in der Boden- und Deckplatte Schlitze für den Durchzug von Kühlluft. Diese wird von zwei Lüftereinsätzen erzeugt, die zwischen der unteren Reihe Gerätegehäuse und dem Schrankboden im Gestell angeordnet sind. Jeder Lüftereinsatz enthält in Einbaurichtung betrachtet nebeneinander zwei vertikal blasende Axiallüfter.

Baugruppenträger, beispielsweise eines 19"-Aufbausystems, die eine unterschiedliche Baugruppenbestückung haben können und übereinander in einem Gestell, Schrank oder Gehäuse montiert werden, sind aus der Druckschrift DE-U- 87 14 894 bekannt. Bei einem als Tischgehäuse konzipierten Ausführungsbeispiel befinden sich neben den Seitenwänden des vorn offenen Gehäuses, das im Boden und auf der Oberseite mit Lüftungsschlitzen versehen ist, vertikale Profilschienen, an denen seitliche Flansche des Baugruppenträgers und die Frontplatte eines Lüftereinsatzes angeschraubt werden, wobei letzterer anstelle eines Bodens einen integrierten Filtermatten-Einschub hat. An den vertikalen Profilschienen horizontal befestigte Führungsschienen erleichtern die Montage des Lüftereinsatzes. Hinter der Frontplatte des Lüftereinsatzes sind nebeneinander zwei vertikal blasende Axiallüfter und im Raum dahinter, mit den Anschlußleitungen der Axiallüfter verbundene Anschlußklemmen für externe Leitungen angeordnet.

Bei einem signalisierten Defekt oder des Ablaufs der Lebensdauer eines Axiallüfters ist der Austausch umständlich und zeitraubend. Außerdem setzt dies voraus, daß der Lüftereinsatz zum Abklemmen der externen Leitungen von der Rückseite des Gehäuses zugänglich sein muß, bevor die Befestigung an den vertikalen Profilschienen gelöst und der Lüftereinsatz ausgebaut werden kann. Andernfalls müssen die externen Leitungen eine Überlänge haben, so daß sie zusammen mit dem Lüftereinsatz aus dem Gehäuse herausziehbar sind. Dies erfordert unerwünschterweise zusätzlichen Raum zur Unterbringung der Vorratslängen im Gehäuse.

Der Erfindung liegt die Aufgabe zugrunde, eine optimale Kühlung der Steckbaugruppen von Baugruppenträgern mittels einer Axiallüfter verwendenden Belüftungseinrichtung sicherzustellen, die bedarfsweise einen einfachen und raschen Austausch von Axiallüftern gestattet. Diese Aufgabe wird erfindungsgemäß von einem Baugruppenträger mit den Merkmalen des Patentanspruchs 1 gelöst.

Die Vorteile der Lösung bestehen unter anderem darin, daß der Austausch des Lüftereinschubs bei in Betrieb befindlicher Einrichtung vorgenommen werden kann, da weder Anschlußkabel noch Befestigungsschrauben gelöst werden müssen. Weil das Auswechseln des Lüftereinschubs mit wenigen Handgriffen vornehmbar ist, tritt nur eine kurze Unterbrechung des Kühlluftstromes auf, die keine unzulässige Erwärmung der zu kühlenden Steckbaugruppen verursacht. Auch das Steuermodul ist mittels Steckverbinder in den Baugruppenträger einsteckbar, so dass gegebenenfalls ein müheloser Austausch des Steuermoduls möglich ist. Ausgestaltungen des Gegenstandes gemäß Patentanspruch 1 sind in den Unteransprüchen angegeben. Weitere erzielbare Vorteile sind der Beschreibung zu entnehmen.

Die Erfindung wird anhand eines in Zeichnungen dargestellten Ausführungsbeispiels wie folgt näher beschrieben. In den Zeichnungen zeigen:
- Fig. 1: einen geöffneten Schrank mit fünf im Schrank an einem Gestellrahmen befestigten Baugruppenträgern vor der Bestückung mit Steckbaugruppen, in perspektivischer Ansicht;
- Fig. 2: einen Baugruppenträger der Fig. 1 vor der Montage von Führungsschienen für Lüftereinschübe, perspektivisch dargestellt;
- Fig. 3: einen mit Steckbaugruppen und Lüftereinschüben bestückten Baugruppenträger, teilweise ausgeschnitten, in der Vorderansicht;
- Fig. 4: die schematische Darstellung eines gemäß Fig. 3 oberhalb der Lüftereinschübe horizontal geschnittenen Baugruppenträgers, in der Draufsicht.

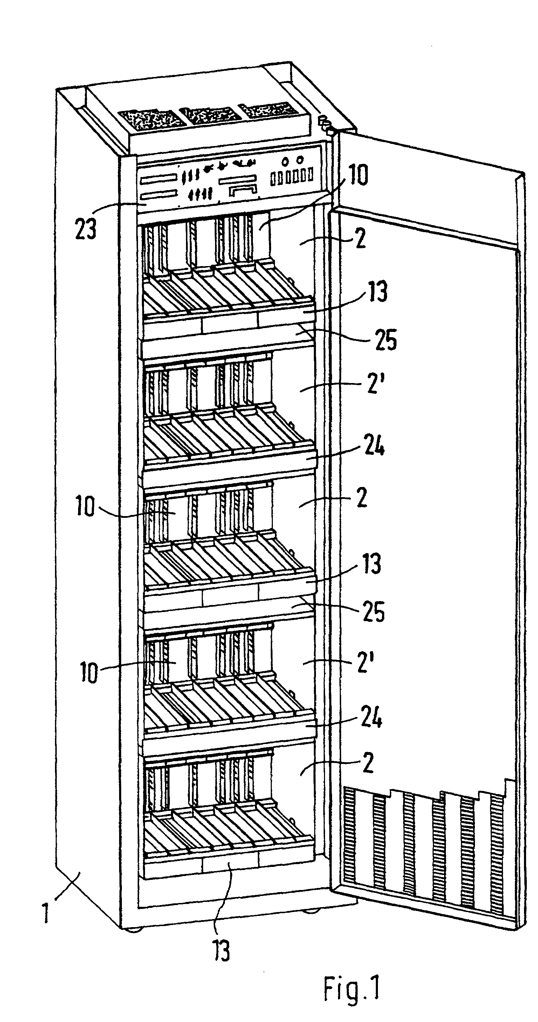

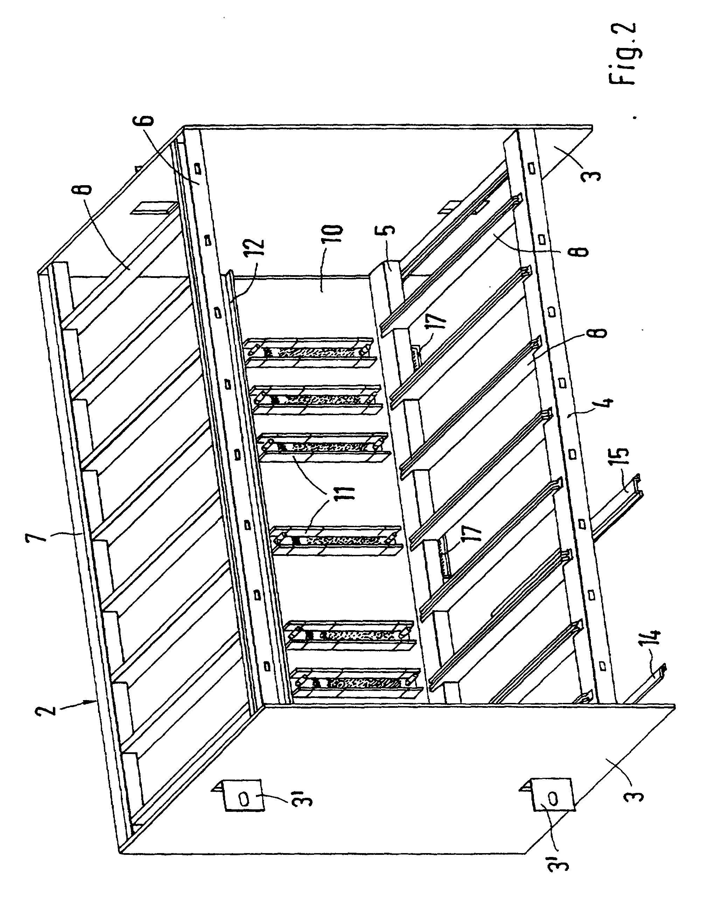

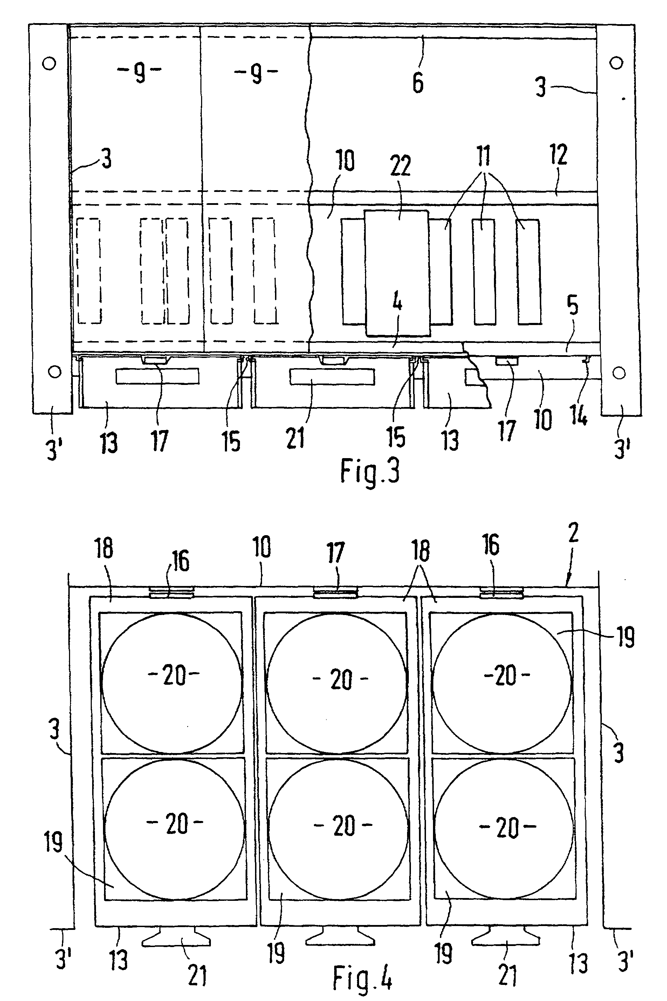

In Fig. 1 ist der Schrank mit Tür insgesamt mit 1 bezeichnet. Es handelt sich um eine Ausführung mit Gestellrahmen, dessen vertikale Holme z.B. aus separaten, im Querschnitt L-förmigen Schienen oder auch aus dem Schrankblech gebogenen Profilschienen bestehen und an denen im Vollausbau beispielsweise fünf Baugruppenträger 2 übereinander befestigt sind. Wie die Fig. 2 und 3 zeigen, besteht ein derartiger Baugruppenträger 2 üblicherweise aus zwei Seitenwänden 3 mit nach außen gerichteten Befestigungsflanschen 3' und mehreren, die Seitenwände verbindenden Querträgern. Es sind dies im unteren Bereich ein erster vorderer und ein zweiter rückwärtiger Querträger 4, 5 sowie ein dritter und vierter Querträger 6, 7, welche die oberen Ecken der Seitenwände 3 vorn und hinten miteinander verbinden. An beiden unteren und beiden oberen Querträgern 4, 5 und 6, 7 sind in vorgegebenem Teilungsabstand nebeneinander Führungsleisten 8 für wenigstens teilweise mit Kühlrippen versehene Steckbaugruppen 9 (Fig. 3) befestigt, die an einer Rückwand 10 des Baugruppenträgers 2 auf der Vorderseite sitzende Steckverbinder 11 kontaktieren. Die Rückwand 10 ist in bekannter Weise als Verdrahtungsplatte ausgebildet und an den rückwärtigen Querträgern befestigt.

Bei der Bauweise des Baugruppenträgers 2 der vorliegenden Ausführung hat die Verdrahtungs-Rückwand 10 zur ungehinderten Luftzirkulation eine reduzierte Bauhöhe. Daher ist zwischen dem zweiten und vierten rückwärtigen Querträger 5, 7 ein fünfter Querträger 12 vorgesehen, an dem das obere Ende der Rückwand 10 befestigt ist. Außerdem sind hier die Seitenwände 3 in der Vertikalen länger ausgeführt und stehen unterhalb der beiden unteren Querträger 4,5 über, wodurch ein seitlich begrenzter Raum für die Unterbringung von als Schubladen ausgebildeten Lüftereinschüben 13 (Fig. 3 und 4) vorhanden ist. Zur Halterung der Lüftereinschübe 13 dienen an den Unterseiten der beiden unteren Querträger 4, 5 befestigte Führungsschienen. Ist in den Baugruppenträger 2 nur ein einziger, die gesamte Breite einnehmender Lüftereinschub 13 integriert, werden nur zwei Führungsschienen 14 benötigt, von denen je eine unmittelbar neben den Seitenwänden 3 angeordnet ist. Die Führungsschienen 14 haben in diesem Fall einen Z-artigen Querschnitt. Natürlich können auch Führungsschienen 14 L-förmigen Querschnitts vorgesehen werden, die dann jedoch an den Seitenwänden 3 innen befestigt sind. Sollen zwei Lüftereinschübe 13 halber Breite vorgesehen werden, ist an den unteren Querträgern 4, 5 in der Mitte zusätzlich eine als Hutschiene ausgebildete Führungsschiene 15 angeordnet.

Zur besseren Anpassung der Kühlleistung an unterschiedliche Erfordernisse hat der Baugruppenträger 2 jedoch vorzugsweise drei in einer Ebene nebeneinander angeordnete Lüftereinschübe 13 identischer Ausführung. Zwischen den beiden Z-artigen Führungsschienen 14 sind dann zwei hutförmige Führungsschienen 15 in passendem Abstand voneinander befestigt (Fig. 3). Die Führungsschienen 14, 15 sind beispielsweise einfache, aus Blech gestanzte Biegeteile, die kostengünstig hergestellt und z.B. durch Punktschweißen an den ebenfalls aus Stahlblech gefertigten Querträgern 4, 5 befestigt werden können. Da der Lüftereinschub 13 als Steckbaugruppe konzipiert ist, die am rückwärtigen Ende einen Steckverbinder 16 hat, steht die Rückwand 10 des Baugruppenträgers 2 hinten unterhalb seines unteren Querträgers 5 in vertikaler Richtung etwas vor und trägt die komplementären Steckverbinder 17.

Die Schublade 18 des Lüftereinschubs 13 besteht aus einem einstückigen Spritzteil aus Kunststoff. Sie ist in Einschubrichtung gesehen in zwei hintereinander liegende, oben offene Fächer 19 zur Aufnahme je eines vertikal blasenden Axiallüfters 20 ausgebildet und hat im Boden jedes Faches 19 wenigstens eine Luftansaugöffnung. Außerdem weist die Schublade 18 zur Halterung und Führung an beiden Außenseiten der Seitenwände je eine oben bündig abschließende, mit den Führungsschienen 14, 15 im Baugruppenträger 2 korrespondierende Gleitleiste auf. Um bei einem Baugruppenträger 2 mit gezogener Steckbaugruppe 9 und laufenden Axiallüftern 20 einen versehentlichen manuellen Durchgriff zu verhindern, sind die Fächer 19 zur Sicherheit mit einem auf die Schublade 18 aufgerasteten Kunststoffgitter abgedeckt. Zweckmäßigerweise ist die Schublade 18 an der Frontseite mit einem angeformten Ziehgriff 21 und an geeigneter Stelle mit wenigsten einer Rastnase zur Arretierung des Lüftereinschubs 13 im Baugruppenträger 2 versehen. Die Arretierung kann jedoch auch so mit dem Ziehgriff 21 gekoppelt sein, daß beim Einsetzen des Lüftereinschubs 13 eine selbsttätige Verriegelung erfolgt und die Entriegelung mit dem Ziehgriff 21 vornehmbar ist (nicht dargestellt). Innerhalb der Lüftereinschübe 13 sind die Axiallüfter 20 mit ihren rückwärtigen Steckverbindern 16 verdrahtet. Über die Steckverbinder 16 erhalten die Axiallüfter 20 ihre Versorgungsspannung. Außerdem sind Steuer- und Überwachungsleitungen angeschlossen. Die drei an der Rückwand 10 des Baugruppenträgers 2 auf der Vorderseite jeweils passend befestigten komplementären Steckverbinder 17 sind ihrerseits rückwärtig unter anderem mit einem auf der vorderen Seite zwischen zwei Steckverbindern 11 für Steckbaugruppen 9 vorzugsweise steckbar angeordneten Steuermodul 22 verdrahtet. Die Rückwandverdrahtung kann sowohl aus Schaltdrähten als auch aus gedruckten Leiterbahnen der Verdrahtungs-Rückwand 10 oder aus einer zweckmäßigen Kombination der beiden elektrischen Verbindungsarten bestehen.

Die steckbare Anordnung des Steuermoduls 22 hat den Vorteil, daß es nach Entfernen des davor befindlichen Steckeinschubs 9 bedarfsweise mühelos ausgetauscht werden kann. Das Steuermodul 22 ist mit einem Bus-Anschluß versehen, über den die Position jedes Axiallüfters 20 von allen im Gestellrahmen angeordneten Baugruppenträgern 2 von einer Steuereinheit 23 abgefragt werden kann. Auf diese Weise lassen sich Defekte feststellen und die Geschwindigkeit je nach Kühlungsbedarf individuell steuern, so daß innerhalb eines Baugruppenträgers 2 die vordere Lüfterreihe z.B. mit einer von der hinteren Lüfterreihe abweichenden Geschwindigkeit läuft oder die im Gestellrahmen unten angeordneten Axiallüfter 20 langsamer drehen als die in den Lüftereinschüben 13 eines im Gestellrahmen in höherer Position befestigten Baugruppenträgers 2 befindlichen. Im übrigen lassen sich die Steckverbinder 16 der Lüftereinschübe 13 mittels einer Draht- oder Diodenbrücke so codieren, daß die Codierung z. B. das Herstellungsjahr des Lüftereinschubs 13 enthält. Diese Information kann ebenfalls über den Bus-Anschluß des Steuermoduls 22 von der zentralen Steuereinheit 23 gelesen und ein nahender Ablauf der etwa 5,5 jährigen Lebensdauer der Axiallüfter 20 signalisiert werden. Die zentrale Steuereinheit 23 ist beispielsweise Teil eines Mobilfunksystems und im Schrank 1 einer Basisstation untergebracht.

Die vertikalen Holme des Gestellrahmens einer derartigen Basisstation haben jeweils eine in vorgegebenem Rastermaß angeordnete Lochreihe für die Befestigung der Baugruppenträger 2. Wie Fig. 1 zeigt, hat der Schrank 1 eine Höhe von beispielsweise etwa zwei Metern, die einen Vollausbau mit fünf Baugruppenträgern gestattet. Je nach in den Steckbaugruppen 9 erzeugter Verlustleistung und Position der Baugruppenträger im Gestellrahmen werden mit Lüftereinschüben 13 voll bestückte Baugruppenträger 2 und Baugruppenträger 2' ohne Lüftereinschübe und ohne Steuermodule angeordnet, die jedoch bei Bedarf ohne weiteres nachrüstbar sind. Die in den Baugruppenträger 2 integrierte Anordnung von drei Lüftereinschüben 13 nebeneinander, die voneinander unabhängig gesteckt oder gezogen werden können, gestatten es an den Frontseiten der Steckbaugruppen 9 ankommende und abgehende HF-Kabel zwischen den verschiedenen Einschubebenen direkt vertikal und somit auf kurzem Weg zu führen, da zum Auswechseln der relativ schmalen Lüftereinschübe 13 nur eine minimale seitliche Auslenkung der Frontverkabelung erforderlich ist.

Bei dem dargestellten Ausführungsbeispiel der Basisstation hat der Schrank 1 vom Boden zur Decke betrachtet einen gemischten Einbau. Dem unteren, mit Lüftereinschüben 13 bestückten ersten Baugruppenträger 2 folgt ein zweiter Baugruppenträger 2' ohne Lüftereinschübe, bei dem der leere Raum mittels einer aufgeschnappten Frontblende 24 abgedeckt ist. Über diesem Baugruppenträger 2' ist eine den Boden eines Luftansaugfachs 25 bildende Platte vorgesehen, welche die Ableitung von aufsteigender Warmluft in einen rückwärtigen Abluftschacht des Schrankes 1 bewirkt. Über dem Luftansaugfach 25 ist wieder ein mit Lüftereinschüben 13 bestückter dritter Baugruppenträger 2 und darüber ein mit Frontblende 24 abgedeckter vierter Baugruppenträger 2', ein weiteres Luftansaugfach 25 und ein fünfter Baugruppenträger 2 mit Lüftereinschüben 13 angeordnet. Im darüber liegenden Teil des Schrankes 1 sind schließlich unter anderem die zentrale Steuereinheit 23 der Basisstation und weitere drei Lüftereinschübe 13 (Toplüfter) mit gleicher Steuerelektronik (Steuermodul 22) untergebracht. Ein Gestellrahmen, in dem fünf mit Lüftereinschüben 13 voll bestückte Baugruppenträger 2 montiert sind, kann somit sechsunddreißig individuell steuerbare Axiallüfter 20 enthalten.

## Patentansprüche

1. Gestellrahmen der Nachrichtentechnik mit mindestens einem Baugruppenträger (2, 2'), der eine Steckverbinder (11) aufweisende Verdrahtungs-Rückwand (10) für einsetzbare Steckbaugruppen (9) hat, und mit mindestens einer, wenigstens einen vertikal blasenden Axiallüfter (20) enthaltenden Belüftungseinrichtung zur Kühlung der Steckbaugruppen (9), wobei die Belüftungseinrichtung aus einem steckbar in den Baugruppenträger (2) integrierten Lüftereinschub (13) besteht, der rückseitig wenigstens einen Steckverbinder (16) hat, welcher einen komplementären Steckverbinder (17) an der Verdrahtungs-Rückwand (10) kontaktiert,
**dadurch gekennzeichnet,**
**dass** der Baugruppenträger (2, 2') mit mehreren, an unteren Querträgern (4, 5) befestigten Führungsschienen (14, 15) zum Einschieben von Gleitleisten des Lüftereinschubes (13) versehen ist und **dass** auf der Vorderseite der Verdrahtungs-Rückwand (10) ein mit den Steckverbindern (16, 17) für die Lüftereinschübe (13) elektrisch verbundenes Steuermodul (22) zur individuellen Steuerung der Axiallüfter (20) vorgesehen ist, wobei das Steuermodul (22) steckbar zwischen zwei der Kontaktierung von Steckbaugruppen (9) dienenden Steckverbindem (11) angeordnet ist.

2. Gestellrahmen mit Baugruppenträger nach Anspruch 1, **dadurch gekennzeichnet, dass** die Führungsschienen (14, 15) an den Querträgern (4, 5) und die Steckverbinder (17) für die Lüftereinschübe (13) an der Verdrahtungs-Rückwand (10) eine Anordnung aufweisen, welche nebeneinander das Einstecken von drei Lüftereinschüben (13) gestattet.

3. Gestellrahmen mit Baugruppenträger nach einem der vorangehenden Ansprüche, **dadurch gekennzeichnet, dass** der Lüftereinschub (13) aus einer Schublade (18) und zwei mit einem rückwärtigen Steckverbinder (16) der Schublade (18) verdrahteten Axiallüftern (20) besteht.

4. Gestellrahmen mit Baugruppenträger nach Anspruch 3, **dadurch gekennzeichnet, dass** die Schublade (18) ein einstückiges Kunststoffspritzteil mit zwei in Steckrichtung hintereinander angeordneten Fächern (19) zur Aufnahme je eines vertikal blasenden Axiallüfters (20) ist.

5. Gestellrahmen mit Baugruppenträger nach einem der vorangegangen Ansprüche, **dadurch gekennzeichnet, dass** bei einem mit mehreren Baugruppenträgern (2) bestückten Gestellrahmen sämtliche Steuermodule (22) über Bus-Anschlüsse mit einer im Gestellrahmen untergebrachten zentralen Steuereinheit (23) elektrisch verbunden sind.

## Claims

1. Telecommunications rack having at least one subrack (2, 2'), which has a wiring backplane (10) comprising connectors (11) for insertable plug-in modules (9), and having at least one ventilating device comprising at least one vertically blowing axial-flow fan (20) for cooling the plug-in modules (9), wherein the ventilating device comprises a withdrawable fan unit (13), which is integrated in a plug-in manner in the subrack (2) and at the rear has at least one connector (16), which contacts a complementary connector (17) on the wiring backplane (10),
**characterized in that**
the subrack (2, 2') is provided with a plurality of guide rails (14, 15) fastened to bottom transverse bars (4, 5) for the insertion of sliding ledges of the withdrawable fan unit (13) and that at the front of the wiring backplane (10) a control module (22), which is electrically connected to the connectors (16, 17) for the withdrawable fan units (13), is provided for individual control of the axial-flow fans (20), wherein the control module (22) is disposed in a plug-in manner between two connectors (11) used for contacting the plug-in modules (9).

2. Rack with subrack according to claim 1, **characterized in that** the guide rails (14, 15) are arranged on the transverse bars (4, 5) and the connectors (17) for the withdrawable fan units (13) are arranged on the wiring backplane (10) in a way that allows three withdrawable fan units (13) to be inserted side by side.

3. Rack with subrack according to one of the preceding claims, **characterized in that** the withdrawable fan unit (13) comprises a drawer (18) and two axial-flow fans (20) wired up to a rear connector (16) of the drawer (18).

4. Rack with subrack according to claim 3, **characterized in that** the drawer (18) is an integral injection-moulded plastic part having two compartments (19) disposed successively in insertion direction for receiving in each case a vertically blowing axial-flow fan (20).

5. Rack with subrack according to one of the preceding claims, **characterized in that**, in a rack equipped with a plurality of subracks (2), all of the control modules (22) are electrically connected by bus ports to a central control unit (23) housed in the rack.

## Revendications

1. Ossature d'armoire de télécommunication avec au moins un support de baies (2, 2') ayant une paroi arrière de câblage (10) comprenant des connecteurs (11) pour des composants enfichables (9) et avec au moins un dispositif de ventilation pour le refroidissement des composants enfichables (9) comprenant au moins un ventilateur axial soufflant en direction verticale (20), le dispositif de ventilation se composant d'un caisson extractible de ventilation (13) intégré de manière enfichable dans le support de baies (2) et dont la face arrière comprend au moins un connecteur (16) qui se met en contact avec un connecteur complémentaire (17) se trouvant sur la paroi arrière de câblage (10), **caractérisée en ce que** le support de baies (2, 2') est muni de plusieurs rails de guidage (14, 15) fixés sur des traverses inférieures (4, 5) et destinés à l'introduction de barres de glissement du caisson extractible de ventilation (13) et **en ce que** sur le côté avant de la paroi arrière de câblage (10) est prévu un module de commande (22, relié électriquement avec les connecteurs (16, 17) pour les caissons extractibles de ventilation (13) et servant au pilotage individuel des ventilateurs axiaux (20), le module de commande (22) étant disposé de manière enfichable entre deux connecteurs (11) servant à la mise en contact de composants enfichables (9).

2. Ossature d'armoire support de baies selon la revendication 1, **caractérisée en ce que** la disposition des rails de guidage (14, 15) sur les traverses (4, 5) et celle des connecteurs (17) pour les caissons extractibles de ventilation (13) sur la paroi arrière de câblage (10) permettent de mettre en place côte à côte trois caissons extractibles de ventilation (13).

3. Ossature d'armoire support de baies selon l'une des revendications précédentes, **caractérisée en ce que** le caisson extractible de ventilation (13) se compose d'un tiroir (18) et de deux ventilateurs axiaux (20) câblés au moyen d'un connecteur arrière (16) du tiroir (18).

4. Ossature d'armoire support de baies selon la revendication 3, **caractérisée en ce que** le tiroir (18) est une pièce monobloc moulée par injection en matériau synthétique avec deux casiers (19) disposés l'un derrière l'autre en direction d'enfichage et servant à recevoir respectivement un ventilateur axial (20) soufflant en direction verticale.

5. Ossature d'armoire support de baies selon l'une des revendications précédentes, **caractérisée en ce que**, dans le cas d'une ossature d'armoire équipée de plusieurs supports de baies (2), tous les modules de commande (22) sont reliés électriquement au moyen de raccordements de bus avec une unité de commande centrale (23) disposée dans l'ossature d'armoire.
